Europäisches Patentamt

European Patent Office

Office européen des brevets

(19)

(11) **EP 0 468 416 B1**

(12) **EUROPÄISCHE PATENTSCHRIFT**

(45) Veröffentlichungstag und Bekanntmachung des Hinweises auf die Patenterteilung:
**25.09.1996 Patentblatt 1996/39**

(51) Int Cl.6: **H03F 3/08**

(21) Anmeldenummer: **91112260.4**

(22) Anmeldetag: **22.07.1991**

(54) **Schaltungsanordnung zum Verstärken kleiner Sensorströme**

Circuit arrangement for amplifying small sensor currents

Arrangement de circuit pour amplifier de petits courants d'un capteur

(84) Benannte Vertragsstaaten:
**CH DE FR GB LI**

(30) Priorität: **24.07.1990 DE 4023435**

(43) Veröffentlichungstag der Anmeldung:
**29.01.1992 Patentblatt 1992/05**

(73) Patentinhaber: **IC-HAUS GmbH**
**D-55294 Bodenheim (DE)**

(72) Erfinder:
• **Flocke, Heiner, Dr.-Ing.**
**W-6501 Bodenheim (DE)**
• **Herz, Manfred**
**W-6500 Mainz 43 (DE)**

(74) Vertreter: **Blumbach, Kramer & Partner Patentanwälte,**
**Sonnenberger Strasse 100**
**65193 Wiesbaden (DE)**

(56) Entgegenhaltungen:
**US-A- 4 259 643          US-A- 4 504 797**
**US-A- 4 904 860**

**Beschreibung**

Die Erfindung betrifft eine Schaltungsanordnung nach dem Oberbegriff des Anspruchs 1.

Die von Sensoren gelieferten Ströme sind häufig außerordentlich klein. Das gilt insbesondere auch für die Fotoströme, die eine Fotodiode bei Bestrahlung liefert. Zur Auswertung der Fotoströme ist daher eine Stromverstärkung erforderlich, die nicht nur hohe Verstärkungsfaktoren erfordert, sondern außerdem auch möglichst konstant sein muß, damit die verstärkten Signalströme die jeweiligen Sensorströme genau und verläßlich wiedergeben.

In bekannter Weise benutzt man zur Verstärkung solcher Sensorströme einen in Emitterschaltung betriebenen Transistor, an dessen Basis der jeweilige Sensor, beispielsweise eine Fotodiode, angeschlossen ist. Im Kollektorkreis des Transistors liegt eine Konstantstromquelle und der Basis wird vom Kollektor her über einen sehr hohen Widerstand ein Gegenkopplungsstrom zugeführt, der den jeweiligen Fotostrom kompensiert. Der verstärkte Gegenkopplungsstrom gibt dann den Fotostrom genau wieder. Nachteilig ist hierbei jedoch, daß sich die erforderlichen hohen Widerstandswerte, die bei Fotoströmen im Nano- und Mikroamperebereich, beispielsweise im Bereich von 10 MΩ und mehr liegen, nur schwer reproduzierbar zu verwirklichen sind, insbesondere dann, wenn die Verstärkungsschaltung Teil einer integrierten Schaltung ist. Außerdem reichen die erzielbaren Verstärkungsfaktoren häufig nicht aus.

Der Erfindung liegt demgemäß die Aufgabe zugrunde, eine Verstärkungsschaltung für kleine Sensorströme anzugeben, die bei kleinem Aufwand hohe Verstärkungsfaktoren ermöglicht und sich gut in integrierter Form verwirklichen läßt. Die Lösung der Aufgabe ist im Patentanspruch 1 angegeben.

Der Stromuntersetzungsfaktor läßt sich bei einem Stromspiegel sehr genau und reproduzierbar einstellen und einhalten. Insbesondere dann, wenn nach einer Weiterbildung der Erfindung der Summenstrom des ersten Stromspiegels einer weiteren Stromuntersetzungsschaltung mit einem weiteren Stromspiegel zugeführt ist, dessen Mutter- oder Summenstrom als Signalstrom ausgekoppelt wird, können insgesamt sehr hohe Verstärkungsfaktoren erzielt werden. Dabei besteht dann gegebenenfalls auch die Möglichkeit, auf die gleiche Weise einen dritten oder zusätzliche Stromspiegel mit jeweils einer weiteren Stromuntersetzung nachzuschalten, um den Verstärkungsfaktor weiter zu erhöhen.

Die verwendeten Transistoren können bipolare Transistoren oder auch Feldeffekttransistoren, insbesondere MOS-Transistoren, oder auch Kombinationen sein. Zweckmäßig ist der Transistor, an dessen Basiselektrode der Sensor liegt, zur Erzielung hoher Verstärkungsfaktoren ein Darlington-, insbesondere ein Dreifach-Darlington-Transistor.

Zur Gewinnung des Signalstroms kann der Mutteroder Summenstrom des Stromspiegels bzw. des jeweils letzten Stromspiegels direkt ausgekoppelt werden. Mit Vorteil kann jedoch auch der Summenstrom über eine Folgetransistor ausgekoppelt werden.

Die Schaltungsanordnungen nach der Erfindung eignen sich sowohl zur Verstärkung kleiner Sensorgleichströme als auch kleiner Sensorwechselströme. Häufig ist jedoch einem Sensorgleichstrom ein kleinerer Wechselstrom überlagert, der das eigentliche Nutzsignal darstellt. Das gilt beispielsweise dann, wenn eine Fotodiode mit Gleichlicht bestrahlt ist, dem als Nutzsignal Wechsellicht überlagert ist. Wenn das Wechselstrom-Nutzsignal dann getrennt gewonnen werden soll, besteht in üblicher Weise die Möglichkeit, zur Abtrennung des Gleichstromsignals einen Kondensator vorzusehen. Ein solcher Kondensator muß jedoch verhältnismäßig groß sein und läßt sich daher nicht mit den übrigen Bauelementen der Schaltungsanordnung in Form einer integrierten Schaltung verwirklichen. Zur getrennten Gewinnung eines verstärkten Signalwechselstroms sieht daher eine Weiterbildung der Erfindung vor, daß der Basis- bzw. Gate-Elektrode des Transistors über einen Kondensator ein Gegenkopplungswechselstrom zugeführt ist, wobei der Gegenkopplungswechselstrom mittels einer Stromuntersetzungsschaltung unter Verwendung eines Stromspiegels gewonnen wird, der durch eine dem Signalstrom proportionale Spannung gesteuert wird und dessen Mutter- oder Summenstrom als Signalwechselstrom ausgekoppelt ist. Der gegengekoppelte Wechselstrom ist im Vergleich zum Signalwechselstrom wegen der Verwendung der Stromuntersetzungsschaltung in Form eines Stromspiegels klein, so daß auch der Koppelkondensator sehr klein sein kann. Er läßt sich beispielsweise in Form einer Sperrschichtkapazität in integrierter Form verwirklichen. Die dem Signalstrom proportionale Spannung kann zweckmäßig an einem Widerstand abgegriffen werden, der im Mutterstromkreis des Stromspiegels oder des weiteren Stromspiegels liegt. Die dem Signalstrom proportionale Spannung wird mit Vorteil dem positiven Eingang eines Differenzverstärkers zugeführt, dessen negativer Eingang mit dem Kondensator verbunden ist und über einen Regelkreis der Spannung am positiven Eingang nachgeführt wird. Der Summenstrom des Wechselstromspiegels kann über einen Folgetransistor ausgekoppelt werden, dessen Basis- bzw. Gate-Elektrode mit dem Ausgang des Differenzverstärkers verbunden ist. Der Differenzverstärker kann ein Operationsverstärker sein, läßt sich aber auch in Form eines einzelnen Transistors verwirklichen.

Bei Verwirklichung der Schaltungsanordnung in integrierter Schaltungstechnik werden zweckmäßig die Transistoren des oder der Stromspiegel sowie auch des oder der Wechselstromspiegel als laterale Transistoren in einer Wanne der integrierten Schaltung verwirklicht. Dabei soll zur Erzielung einer hohen Stromuntersetzung das Randlängenverhältnis der beiden Transistoren jedes Stromspiegels einen hohen Wert im Bereich zwischen 3 und 30, vorzugsweise von etwa 10, haben. Bei Verwendung von zwei kaskadierten Stromspiegeln kann der gemeinsame Emitter des ersten Stromspiegels als Rechteck im U-förmigen Kollektor des den Mutterstrom führenden Transistors angeordnet sein. An der offenen Schmalseite des U-förmigen Kollektors liegt dann der gemeinsame Emitter des nachgeordneten Stromspiegels, der als Summenstrom den um das Randlängenverhältnis K kleineren, gespiegelten Kollektorstrom des ersten Stromspiegels aufnimmt. Der Mutterstrom des zweiten Stromspiegels wird abgeleitet, beispielsweise zum Substrat oder auch zum U-förmigen Kollektor, und sein gespiegelter, kleinerer Strom ist der zur Basis des Transistors gegengekoppelte Strom.

Der gemeinsame Emitter des nachgeordneten Stromspiegels kann wiederum als Rechteck zwischen den Schenkeln des U-förmigen Kollektors des den Mutterstrom führenden Transistors des ersten Stromspiegels angeordnet sein, wobei der den gespiegelten Strom führende Kollektor des zweiten Stromspiegels an der Schmalseite des gemeinsamen Emitters liegt.

Nachfolgend werden Ausführungsbeispiele der Erfindung anhand der Zeichnung beschrieben. Es zeigen:

Fig. 1　　ein Ausführungsbeispiel für eine Schaltungsanordnung zur Verstärkung des Fotostroms einer Fotodiode mit einem einzelnen Stromspiegel;

Fig. 2　　die Schaltungsanordnung nach Fig. 1 mit einem kaskadierten, weiteren Stromspiegel;

Fig. 3　　schematisch die als integrierte Schaltung mit lateralen Transistoren verwirklichte Anordnung der Stromspiegel für die Schaltung nach Fig. 2;

Fig. 4　　ein Ausführungsbeispiel für eine Schaltungsanordnung zur getrennten Gewinnung eines verstärkten Wechselsignalstroms.

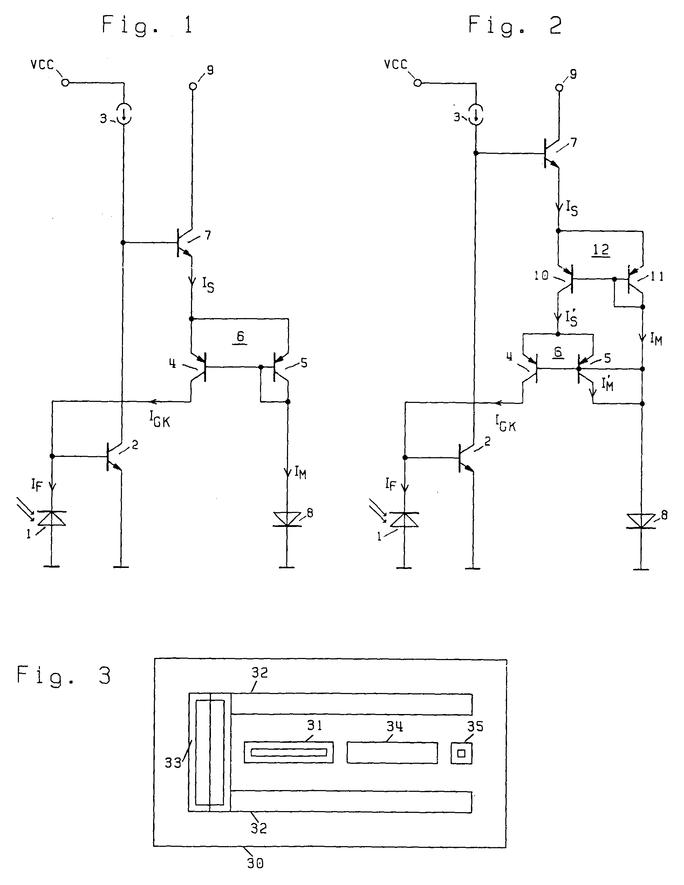

Bei der Schaltungsanordnung nach Fig. 1 ist eine Fotodiode 1 an die Basis eines in Emitterschaltung betriebenen npn-Transistors 2 angeschaltet und liefert einen Fotostrom $I_F$. Im Kollektorstromkreis des Transistors 2 liegt eine Konstantstromquelle 3, die von der Betriebsspannung $V_{CC}$ gespeist wird. Die Konstantstromquelle 3 kann gegebenenfalls auch in Form eines Widerstandes mit hohem Wert verwirklicht sein. Der Basis des Transistors 2 wird über einen pnp-Transistor 4, der mit einem weiteren pnp-Transistor 5 als Stromspiegel 6 geschaltet ist, ein Gegenkopplungsstrom $I_{GK}$ zugeführt. Der Summenstrom $I_S$ des Stromspiegels fließt über einen npn-Folgetransistor 7 zu den beiden Emittern der Stromspiegel-Transistoren 4, 5. Die Basis des Folgetransistors 7 liegt am Kollektor des Transistors 2. Eine Diode 8 sorgt für eine Referenzspannung an der Basis der Stromspiegel-Transistoren 4, 5.

Wenn dafür gesorgt wird, daß der Transistor 5 wesentlich größere Flächen als der Transistor 4 hat, so ist der über den Transistor 5 fließende Mutterstrom $I_M$ um das Flächen- oder Randlängenverhältnis K größer als der über den Transistor 4 fließende, gespiegelte Gegenkopplungsstrom $I_{GK}$. Auf diese Weise wird erreicht, daß der Summenstrom $I_S$ um den Faktor (K+1) größer ist als der durch die Fotodiode 1 fließende Strom. Der Summenstrom $I_S$ stellt also den verstärkten Signalstrom dar, der am Anschluß 9 abgenommen bzw. geliefert werden kann.

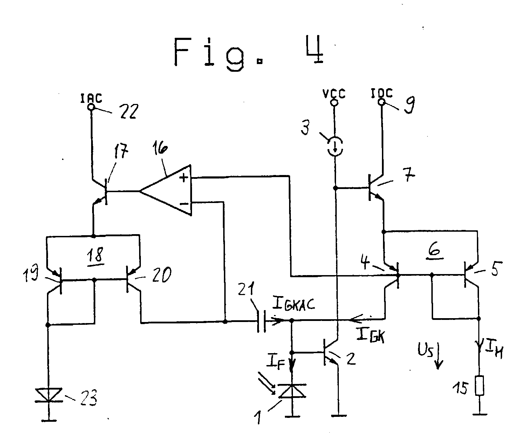

Die Schaltung nach Fig. 2 stimmt in wesentlichen Teilen mit der Schaltung nach Fig. 1 überein. Entsprechende Bauelemente sind daher gleich bezeichnet. Der Unterschied besteht darin, daß der Summenstrom des Stromspiegels 6 mit den Transistoren 4, 5 nunmehr nicht direkt vom Folgetransistor 7 geliefert wird, sondern mittels eines weiteren Stromspiegels 12 mit zwei pnp-Transistoren 10, 11 ebenfalls um einen Faktor K heruntergeteilt worden ist. Der Summenstrom $I'_S$ des Stromspiegels 6, der vom Kollektor des Transistors 10 als gespiegelter Strom kommt, ist dann wiederum um den Faktor K kleiner als der Mutterstrom $I_M$ des Stromspiegels 12, der über den Transistor 11 fließt. Der Gesamtsummenstrom $I_S$, der wiederum der Signalstrom ist, hat dann den Wert

$$I_S = I_F \cdot (K + 1)^2 \cdot$$

Bei einem angenommenen Wert K = 9 erhält man dann den Verstärkungsfaktor 100. Würde man auf die gleiche Weise einen weiteren Stromspiegel kaskadieren, so ergäbe sich ein Verstärkungsfaktor 1000 usw.

Der verstärkte Signalstrom könnte anstelle des Summenstroms $I_S$ auch als Mutterstrom $I_M$ abgenommen werden. Anstelle der Diode 8 kann dann als Referenzspannungsquelle beispielsweise ein weiterer Stromspiegel dienen.

Fig. 3 zeigt die praktische Verwirklichung der beiden Stromspiegel 6, 12 der Schaltung nach Fig. 2 als integrierte Schaltung, wobei in der Figur eine einzelne Wanne 30 der integrierten Gesamtschaltung dargestellt ist. Der Stromspiegel 12 besitzt eine gemeinsame, rechteckige Emitterfläche 31 für die Transistoren 10, 11. Der Kollektor des Transistors 11 wird durch einen U-förmigen Streifen 32 gebildet, der den Emitter 31 umgibt. Die Basis wird durch eine Fläche 33 gebildet, die, wie auch Fig. 2 zeigt, mit dem U-förmigen Kollektor 32 direkt verbunden ist. Der Kollektor des Transistors 10, der gleichzeitig der gemeinsame Emitter der Transistoren 4, 5 des Stromspiegels 6 ist, ist die der Schmalseite der Emitterfläche 31 gegenüberliegende Schmalseite einer weiteren Emitterfläche 34 für die Transistoren 4, 5 des Stromspiegels 6. Der den Mutterstrom führende Kollektor des Transistors 5 wird durch die den langen Seiten der Emitterfläche 34 gegenüberliegenden, parallel verlaufenden Teile des U-förmigen Streifens 32 gebildet. Der Kollektor des Transistors 4 ist das der anderen Schmalseite der Emitterfläche 34 gegenüberliegende Quadrat 35. Die Flächen 31, 32, 33 und 35 besitzen jeweils Kontaktflächen, während für die gemeinsame Emitterfläche 34 ein äußerer Anschluß nicht erforderlich ist.

Man erkennt, daß für beide Stromspiegel 6, 12 die jeweils wirksame Randfläche des einen Kollektors wesentlich größer als die des anderen Kollektors ist. So wird die wirksame Randlänge des Kollektors für den Transistor 11 durch diejenigen Teile des Streifens 32 gebildet, die den beiden langen Seiten und einer Schmalseite der gemeinsamen Emitterfläche 31 gegenüberliegen. Die verbleibende Randlänge für den Kollektor des Transistors 10 ist durch die Länge der Schmalseite der weiteren Emitterfläche 34 bestimmt und demgemäß wesentlich kleiner. Entsprechendes gilt für das Randlängenverhältnis des Stromspiegels 6 mit den Transistoren 4, 5. Auch hier ist die wirksame Randlänge des Kollektors für den Transistor 5, die durch die beiden langen Seiten der Emitterfläche 34 bestimmt wird, wesentlich größer als die Randlänge für den Kollektor des Transistors 4, die der Seitenlänge des Quadrats 35 entspricht.

Die Schaltungsanordnung gemäß Fig. 4 entspricht im rechten Teil mit der Fotodiode 1, dem Transistor 2, dem Stromspiegel 6 und dem Folgetransistor 7 im wesentlichen der Schaltungsanordnung gemäß Fig. 1. Es wurden daher gleiche Bezugszeichen verwendet. Abweichend von der Schaltungsanordnung nach Fig. 1 fließt der Mutterstrom $I_M$ des Stromspiegels 6 über einen Widerstand 15, an welchem eine dem Fotostrom proportionale Signalspannung $U_S$ abfällt. Diese Spannung $U_S$ wird dem nichtinvertierenden Eingang eines Operationsverstärkers 16 zugeführt. Der Ausgang des Operationsverstärkers 16 steuert einen Folgetransistor 17, dessen Emitterstrom einen Stromspiegel 18 mit zwei Transistoren 19, 20 speist. Der Operationsverstärker 16 bildet zusammen mit dem Folgetransistor 17 und dem Transistor 20 einen Regelkreis, der dafür sorgt, daß am invertierenden Eingang des Operationsverstärkers 16 die gleiche Spannung $U_S$ wie am nichtinvertierenden Eingang anliegt. Über den Kondensator 21 wird demgemäß der Basis des Transistors 2 ein Gegenkopplungswechselstrom $I_{GKAC}$ zugeführt, der der Signalspannung $U_S$, der Frequenz und dem Kapazitätswert des Kondensators 21 proportional ist. Wie bei dem Stromspiegel 6 ist dafür gesorgt, daß der Transistor 19 wesentlich größere Flächen als der Transistor 20 hat, so daß der über den Transistor 19 fließende Mutterstrom $I_M$ um das Flächen- oder Randlängenverhältnis größer als der über den Transistor 20 fließende, gespiegelte Strom ist. Der Summenstrom IAC am Anschluß 20 stellt dadurch einen verstärkten Signalwechselstrom dar, der am Anschluß 22 abgenommen bzw. geliefert werden kann. Eine Diode 23 sorgt wiederum für eine Referenzspannung an der Basis der Stromspiegeltransistoren 19, 20.

Der Kondensator 21 kann wegen der Stromuntersetzungsschaltung mittels des Stromspiegels 6 sehr klein sein, beispielsweise einen Wert im Bereich von 20 pF haben und daher durch eine Sperrschichtkapazität in integrierter Form verwirktlicht werden. Ähnlich wie bei der Schaltungsanordnung nach Fig. 2 kann der Stromspiegel 18, der hier zur besseren Unterscheidung auch als Wechselstromspiegel bezeichnet wird, durch eine Kaskadenschaltung von zwei oder mehr Stromspiegeln ersetzt werden, um einen weiter verstärkten Signalwechselstrom zu erhalten.

Die praktische Verwirklichung des Stromspiegels 18 und gegebenenfalls nachgeschalteter weiterer Stromspiegel kann wiederum nach der anhand von Fig. 3 beschriebenen Weise erfolgen.

Die untere Frequenzgrenze der Schaltungsanordnung nach Fig. 4 wird durch den Wert des Widerstandes 15 und des Kondensators 21 sowie das Stromübersetzungsverhältnis des Stromspiegels 6 bestimmt. Sie liegt beispielsweise bei 20 KHz, so daß niederfrequente Störungen, die beispielsweise von Leuchtstoffröhren herrühren, ausgeblendet werden. Die obere Frequenzgrenze wird in üblicher Weise durch parasitäre Kapazitäten und die Eigenschaften der Bauteile bestimmt. Sie liegt beispielsweise bei 1 MHz.

Mit Hilfe der Schaltungsanordnung gemäß Fig. 4 läßt sich demgemäß ein Signalgleichstrom IDC mit einem oberhalb einer durch den Kondensator 21 bestimmten Grenzfrequenz bedämpften Wechselstromanteil am Anschluß 9 entnehmen, der dem eingestrahlten Gleichlicht entspricht, und unabhängig davon ein Signalwechselstrom IAC am Anschluß 22, der dem eingestrahlten Wechsellicht entspricht. Die gesamte Schaltungsanordnung kann als monolithische integrierte Schaltung ausgebildet werden.

**Patentansprüche**

1. Schaltungsanordnung zum Verstärken kleiner Sensorströme, insbesondere des Fotostroms ($I_f$) einer Fotodiode (1), bei der der Sensor über die Basis- bzw. Gate-Elektrode einen in Emitter- bzw. Source-Schaltung betriebenen Transistors (2) steuert, in dessen Kollektor- bzw. Drain-Kreis eine Konstantstromquelle (3) liegt, und mit einer Gegenkopplung zwischen Kollektor- und Basis-Elektrode bzw. Drain- und Gate-Elektrode des Transistors (2), wobei die Gegenkopplung eine erste Stromuntersetzungsschaltung unter Verwendung eines Stromspiegels (6) enthält,
dadurch gekennzeichnet,

daß die Kollektor- bzw. Drainelektrode des Transistors (2) die Basiselektrode eines Folgetransistors (7) ansteuert, dessen Kollektor-Emitter-Strecke den Summenstrom einer zweiten Stromuntersetzungsschaltung (12) liefert, daß der Nebenstrom der zweiten Stomuntersetzungsschaltung (12) den Summenstrom der ersten Stromuntersetzungsschaltung (6) liefert, deren Nebenstrom die Fotodiode (1) gegenkoppelt, und daß der Summenstrom ($I_S$) oder Hauptstrom ($I_M$) der zweiten Stromuntersetzungschaltung (12) als Signalstrom ausge-

koppelt ist.

2. Schaltungsanordnung nach Anspruch 1, dadurch gekennzeichnet, daß der Transistor (2) ein Darlington-, insbesondere ein Dreifach-Darlington-Transistor ist.

3. Schaltungsanordnung nach Anspruch 1 oder 2, daß der Basis- bzw. Gate-Elektrode des Transistors (2) über einen Kondensator (21) ein Gegenkopplungswechselstrom ($I_{GKAC}$) zugeführt ist und daß der Gegenkopplungswechselstrom mittels einer Stromuntersetzungsschaltung unter Verwendung wenigstens eines Wechselstromspiegels (18) gewonnen wird, der durch eine dem Signalstrom ($I_S$) proportionale Spannung ($U_S$) gesteuert wird und dessen Haupt- oder Summenstrom als Signalwechselstrom (IAC) ausgekoppelt ist.

4. Schaltungsanordnung nach Anspruch 3, dadurch gekennzeichnet, daß die dem Signalstrom ($I_S$) proportionale Spannung ($U_S$) an einem Widerstand (15) abgegriffen wird, der im Hauptstromkreis des zweiten Stromspiegels (12) oder des ersten Stromspiegels (6) liegt.

5. Schaltungsanordnung nach Anspruch 3 oder 4, dadurch gekennzeichnet, daß die dem Signalstrom ($I_S$) proportionale Spannung ($U_S$) dem positiven Eingang eines Differenzverstärkers (16) zugeführt ist, dessen negativer Eingang mit dem Kondensator (21) verbunden ist und über einen Regelkreis (16, 17, 20) der Spannung am positiven Eingang nachgeführt wird.

6. Schaltungsanordnung nach Anspruch 5, dadurch gekennzeichnet, daß der Summenstrom des Wechselstromspiegels (18) über einen Folgetransistor (17) ausgekoppelt ist, dessen Basis- bzw. Gate-Elektrode mit dem Ausgang des Differenzverstärkers (16) verbunden ist.

7. Schaltungsanordnung nach einem der Ansprüche 1 bis 6, dadurch gekennzeichnet, daß die Transistoren der Stromspiegel (6, 12, 18) als laterale Transistoren in einer Wanne (30) einer integrierten Schaltung verwirklicht sind und daß das Randlängenverhältnis (K) der beiden Transistoren (4, 5; 10, 11; 19, 20) jedes Stromspiegels (6, 12, 18) einen hohen Wert im Bereich von 3 bis 30, vorzugsweise von etwa 10, hat.

8. Schaltungsanordnung nach Anspruch 7 mit zwei Stromspiegeln, dadurch gekennzeichnet, daß der gemeinsame Emitter des zweiten Stromspiegels (12) als Rechteck (31) im U-förmigen Kollektor (32) des den Hauptstrom ($I_M$) führenden Transistors (11) angeordnet ist, daß an der offenen Schmalseite des U-förmigen Kollektors (32) der gemeinsame Emitter (34) des ersten Stromspiegels (6) angeordnet ist und als Summenstrom ($I'_S$) den um den Wert K kleineren, gespiegelten Kollektorstrom des zweiten Stromspiegels (12) aufnimmt und daß der Hauptstrom ($I'_M$) des ersten Stromspiegels (6) abgeleitet wird und sein gespiegelter, kleinerer Strom der zur Basis des Transistors (2) gegengekoppelte Strom ($I_{GK}$) ist.

9. Schaltungsanordnung nach Anspruch 8, dadurch gekennzeichnet, daß der gemeinsame Emitter des ersten Stromspiegels (6) ebenfalls als Rechteck (34) zwischen den Schenkeln des U-förmigen Kollektors (32) des den Hauptstrom ($I_H$) führenden Transistors (11) des zweiten Stromspiegels (12) angeordnet ist und daß der den gespiegelten Strom ($I_{GK}$) führende Kollektor (35) des ersten Stromspiegels (6) an der Schmalseite des gemeinsamen Emitters (34) angeordnet ist.

## Claims

1. Circuit arrangement for the purpose of amplifying small sensor currents, particularly photoelectric currents ($I_f$) from a photodiode (1), in which the sensor controls a transistor (2) in a common-emitter or common-source connection via the base or gate electrode respectively, in which a constant current source (3) is included in the collector or drain circuit of the transistor (2), and with a negative feedback between the collector and base electrode or drain and gate electrode of the transistor (2), wherein the negative feedback contains a first current reducing circuit using a current mirror (6), characterised in

that the collector or drain electrode respectively of the transistor (2) actuates the base electrode of a follower transistor (7), whose collector-emitter path supplies the total current of a second current reducing circuit (12), that the shunt current of the second current reducing circuit (12) supplies the total current of the first current reducing circuit (6), whose shunt current is fed to the photodiode (1) in negative feedback and that the total current ($I_S$) or main current ($I_M$) of the second current reducing circuit (12) is coupled out as a signal current.

2. Circuit arrangement according to claim 1, characterised in that the transistor (2) is a Darlington, in particular a triple Darlington, transistor.

3. Circuit arrangement according to claim 1 or 2, characterised in that the base or gate electrode respectively of the transistor (2) is fed via a capacitor (21) with an alternating current in negative feedback ($I_{G\text{-}KAC}$) and that the alternating negative feedback current is obtained by means of a current reducing circuit using at least one alternating current mirror (18) in which this negative feedback current is controlled by a voltage ($U_S$) proportional to the signal current ($I_S$) and its main or total current is coupled out as alternating signal current (IAC).

4. Circuit arrangement according to claim 3, characterised in that the voltage ($U_S$) proportional to the signal current ($I_S$) is tapped off at a resistor (15) which is in the main circuit of the second current mirror (12) or of the first current mirror (6).

5. Circuit arrangement according to claim 3 or 4, characterised in that the voltage ($U_S$) proportional to the signal current ($I_S$) is fed to the positive input of a differential amplifier (16) whose negative input is connected to the capacitor (21) and tracks the voltage at the positive input by means of a closed-loop control circuit (16, 17, 20).

6. Circuit arrangement according to claim 5, characterised in that the total current of the alternating current mirror (18) is coupled out via a follower transistor (17), whose base or gate electrode respectively is connected to the output of the differential amplifier (16).

7. Circuit arrangement according to any one of claims 1 to 6, characterised in that the transistors of the current mirrors (6, 12, 18) are embodied as lateral transistors in a trough (30) of an integrated circuit, and that the edge/ length ratio (K) of the two transistors (4, 5; 10, 11; 19, 20) of each current mirror (6, 12, 18) is a high value in the range of 3 to 30, preferably approximately 10.

8. Circuit arrangement according to claim 7 comprising two current mirrors, characterised in

that the common emitter of the second current mirror (12) is arranged as a rectangle (31) in the U-shaped collector (32) of the transistor (11) carrying the main current ($I_M$), that the common emitter (34) of the first current mirror (6) is arranged on the open narrow side of the U-shaped collector (32) and absorbs as a total current ($I'_S$) the mirrored collector current of the second current mirror (12) which is reduced by the value K, and that the main current ($I'_M$) of the first current mirror (6) is derived and its mirrored, lesser current is the current ($I_{GK}$) negatively fed back to the base of the transistor (2).

9. Circuit arrangement according to claim 8, characterised in that the common emitter of the first current mirror (6) is likewise arranged as a rectangle (34) between the legs of the U-shaped collector (32) of the transistor (11) carrying the main current ($I_H$) of the second current mirror (12), and that the collector (35) carrying the mirrored current ($I_{GK}$) of the first current mirror (6) is arranged on the narrow side of the common emitter (34).

## Revendications

1. Agencement de circuit pour amplifier de petits courants de capteur, en particulier un courant photoélectrique ($I_f$) d'une photodiode (1), avec laquelle le capteur, par l'intermédiaire de l'électrode de base, respectivement de grille, commande un transistor (2) monté en émetteur, respectivement source, commun dans le circuit de collecteur, respectivement de drain, duquel se trouve une source de courant constant (3), et ayant une contre-réaction entre électrodes de collecteur et de base, respectivement électrodes de drain et de grille, du transistor (2), la contre-réaction contenant un premier circuit de réduction de courant grâce à l'utilisation d'un miroir de courant (6)
    caractérisé en ce que

    l'électrode de collecteur, respectivement de drain, du transistor (2) commande l'électrode de base d'un transistor suiveur (7) dont l'espace collecteur-émetteur délivre le courant de somme d'un deuxième circuit de réduction de courant (12),
    en ce que le courant dérivé du deuxième circuit de réduction de courant (12) délivre le courant de somme du premier circuit de réduction de courant (6), dont le courant dérivé exerce une contre-réaction sur la photodiode (1), et en ce que le courant de somme ($I_S$) ou le courant principal ($I_M$) du deuxième circuit de réduction de courant (12) est prélevé en tant que courant de signal.

2. Agencement de circuit selon la revendication 1, caractérisé en ce que le transistor (2) est un montage de transistor Darlington, en particulier un montage de transistor Darlington triple.

3. Agencement de circuit selon la revendication 1 ou 2, caractérisé en ce qu'un courant alternatif de contre-réaction ($I_{GKAC}$) est envoyé à l'électrode de base, respectivement de grille, du transistor (2) par l'intermédiaire d'un condensateur (21), et en ce que le courant alternatif de contre-réaction est obtenu au moyen d'un circuit de réduction de courant, grâce à l'utilisation d'au moins un miroir de courant alternatif (18), qui est commandé par une tension ($U_S$) proportionnelle au courant de signal ($I_S$) et dont le courant principal ou de somme est prélevé en tant que courant alternatif de signal (IAC).

4. Agencement de circuit selon la revendication 3, caractérisé en ce que la tension ($U_S$) proportionnelle au courant de signal ($I_S$) est prise sur une résistance (15) qui se trouve dans le circuit de courant principal du deuxième miroir de courant (12) ou du premier miroir de courant (6).

5. Agencement de circuit selon la revendication 3 ou 4, caractérisé en ce que la tension ($U_S$) proportionnelle au courant de signal ($I_S$) est envoyée à l'entrée positive d'un amplificateur différentiel (16) dont l'entrée négative est reliée au condensateur (21) et est dirigée sur l'entrée positive par l'intermédiaire d'un circuit de régulation (16, 17, 20) de la tension.

6. Agencement de circuit selon la revendication 5, caractérisé en ce que le courant de somme du miroir de courant alternatif (18) est délivré par l'intermédiaire d'un transistor suiveur (17) dont l'électrode de base, respectivement de grille, est reliée à la sortie de l'amplificateur différentiel 16.

7. Agencement de circuit selon une des revendications 1 à 6, caractérisé en ce que les transistors des miroirs de courant (6, 12, 18) sont réalisés comme des transistors latéraux dans une plaquette (30) d'un circuit intégré et en ce que le rapport (K) des longueurs de bord des deux transistors (4, 5; 10, 11; 19, 20) de chaque miroir de courant (6, 12, 18) a une valeur élevée comprise dans une plage de 3 à 30, de préférence de 10 environ.

8. Agencement de circuit selon la revendication 7 comportant deux miroirs de courant, caractérisé en ce que l'émetteur commun du deuxième miroir de courant (12) est disposé en rectangle (31) dans le collecteur (32) en forme de U du transistor (11) qui conduit le courant principal ($I_M$), en ce que l'émetteur (34) commun du premier miroir de courant (6) est disposé sur le côté étroit du collecteur (32) en forme de U, et, en tant que courant de somme (I's), augmente d'une valeur K le courant de collecteur réfléchi plus petit du deuxième miroir de courant (12), et en ce que le courant principal ($I'_M$) du premier miroir de courant (6) est dérivé, et son courant réfléchi plus petit est le courant de contre-réaction ($I_{GK}$) sur la base du transistor (2).

9. Agencement de circuit selon la revendication 8, caractérisé en ce que l'émetteur commun du premier miroir de courant (6) est également disposé en rectangle (34) entre les branches du collecteur (32) en forme de U du transistor (11) conduisant le courant principal ($I_H$) du deuxième miroir de courant (12) et en ce que le collecteur (35) conduisant le courant réfléchi ($I_{GK}$) du premier miroir de courant (6) est disposé sur le côté étroit de l'émetteur commun (34).

Fig. 1

Fig. 2

Fig. 3

# Fig. 4